# EUROPEAN PATENT APPLICATION

(11) **EP 4 827 306 A1**
(43) Date of publication of application: **21.10.2026**
(21) Application number: 24953263.1
(22) Date of filing: 05.11.2024
(51) Int. Cl.: H10P 72/10, H10F 71/00

(54) **WAFER BOAT**

(71) Applicant: Hanwha Solutions Corporation, Seoul 04541 (KR)
(72) Inventor: KIM, Hyun Woo, Jung-gu Seoul 04541 (KR); KANG, Byung Ju, Jung-gu Seoul 04541 (KR); CHOI, Kwang Hyun, Jung-gu Seoul 04541 (KR)
(74) Representative: Mooser, Sebastian Thomas
(86) International application number: PCT/KR2024/017307
(87) International publication number: WO 2026/100756

(57) **Abstract**

A wafer boat includes a pair of side plates, separators located at a predetermined interval between the pair of side plates and configured to divide a loading region into which a plurality of wafers are inserted, and guide bars configured to support the wafers between the pair of side plates, wherein one or more of the separator and the guide bar have an average surface roughness value (Ra) that is different from the average surface roughness value (Ra) of the pair of side plates.

## Description

### [Technical Field]

The present disclosure relates to a wafer boat.

### [Background Art]

In a process of manufacturing a solar cell or a semiconductor, the process includes forming a thin film by reacting gas molecules on a surface of a wafer. A thin-film formation process is performed using a method of chemical vapor deposition (CVD), atomic layer deposition (ALD), or the like, and a wafer on which a thin film is formed acquires electrical properties. Wafers for forming a thin film are loaded onto a boat and then loaded into a process chamber, and then a thin-film formation process is performed under a predetermined atmosphere, temperature, and pressure.

However, the conventional boat can load only about 100 wafers per boat, which makes it difficult to load a large number of wafers into a process chamber at once. In addition, there is a problem that it takes a long time to load each boat loaded with conventional boat wafers into a process chamber and unload the boat from the process chamber. Furthermore, in the conventional boat, a portion into which a wafer is inserted does not include a member for guiding the insertion of the wafer, which makes it difficult to smoothly insert the wafer into the boat, and in some cases, causes a problem that the wafer is damaged during an insertion process.

### [Description of Invention]

### [Technical Problem]

One or more embodiments may provide a wafer boat capable of loading several hundred or more wafers at once, allowing the wafers to be stably inserted and loaded, easily entering and exiting a process chamber, and having improved durability through surface treatment.

### [Technical Solution]

A wafer boat includes a pair of side plates, separators located at a predetermined interval between the pair of side plates and configured to divide a loading region into which a plurality of wafers are inserted, and guide bars configured to support the wafers between the pair of side plates, wherein one or more of the separators and the guide bars have an average surface roughness value (Ra) that is different from the average surface roughness value (Ra) of the pair of side plates.

The separators and the guide bars may be subjected to a sanding process to have an average surface roughness value (Ra) that is smaller than that of the pair of side plates.

The guide bar may include two first guide bars which include a plurality of first insertion grooves configured to support one side of each of the wafers and a plurality of first insertion protrusions configured to define the plurality of first insertion grooves and are spaced apart from each other, and two second guide bars which include a plurality of second insertion grooves configured to support the other side of each of the wafers and a plurality of second insertion protrusions configured to define the plurality of second insertion grooves, are located below the first guide bars, and are spaced apart from each other by a narrower interval than the two first guides, wherein the plurality of first insertion grooves and the plurality of second insertion grooves have a shape of which a width gradually decreases toward an inner side.

The first guide bar may further include a plurality of first insertion protrusions which are located between the plurality of first insertion grooves and each of which at least a portion of an edge of a surface into which the wafer is inserted is chamfered.

The first insertion protrusion may include a first protruding surface extending obliquely downward, a second protruding surface extending from an end portion of the first protruding surface, a third protruding surface extending obliquely downward from an end portion of the second protruding surface, a first support surface provided at each of two sides of the first protruding surface and provided in contact with the first insertion groove, and a second support surface provided at each of two sides of the third protruding surface and provided in contact with the first insertion groove, wherein a portion of an edge of the second protruding surface in contact with the first support surface is chamfered.

A line of the first support surface in contact with the first insertion groove may gradually decrease in a height direction of the first guide bar, and a portion of the second support surface in contact with the first insertion groove may vertically extend in the height direction of the first guide bar.

The side plate may include a mounting groove, into which both end portions of the separator are inserted, formed in an inner surface of the side plate, and a bracket installed in a cutout portion formed in a lower end portion of the mounting groove to support the separator.

The side plate may include a triangular support groove concavely formed in an outer surface thereof.

The wafer boat may further include a coating layer formed on the guide bar, and an average surface roughness value (Ra) of the coating layer may be smaller than an average surface roughness value (Ra) of the guide bars.

### [Advantageous Effects]

In a wafer boat according to one or more embodiments, a separator and a guide bar, which frequently come into contact with a wafer during insertion, can be surface-treated to have lower surface roughness than other components of the wafer boat, thereby preventing damage to the wafer.

In a wafer boat according to one or more embodiments, a loading region into which a plurality of wafers are inserted is divided through a separator, thereby allowing a deposition gas to uniformly flow to the plurality of wafers.

In a wafer boat according to one or more embodiments, a shape of a portion of a guide bar in contact with a wafer is changed, thereby preventing damage to the wafer.

### [Description of Drawings]

FIG. 1 illustrates a state in which a wafer boat is loaded into a process chamber.
FIG. 2 is a perspective view of the wafer boat.
FIG. 3 is an exploded perspective view of the wafer boat.
FIG. 4 is a plan view of a part of the wafer boat.
FIG. 5 illustrates one surface of side plates.
FIG. 6 illustrates the other surface of the side plate.
FIG. 7 illustrates a first guide bar.
FIGS. 8 and 9 are enlarged views of a part of the first guide bar.
FIG. 10 illustrates a second guide bar.
FIGS. 11 and 12 are enlarged views of a part of the second guide bar.
FIG. 13 is an enlarged view of a part of the second guide bar.

### [Best Mode]

Hereinafter, the present disclosure will be described with reference to embodiments shown in the accompanying drawings. Embodiments to be described are not limited to the contents to be described in the present specification and may have different forms. Therefore, the embodiments are described below only with reference to the drawings to describe aspects and features of the present disclosure.

The present disclosure includes various embodiments and modifications, and specific embodiments of which are illustrated in the drawings and described below. However, the present disclosure is not limited to the above-described embodiments, and includes all modifications, equivalents, and substitutes included in the spirit and scope of the present disclosure.

When an element or layer is referred to as being "on," "connected to," or "coupled to" another element or layer, the element or layer may be directly on, connected to, or coupled to another element or layer. Alternatively, one or more additional elements or layers may be additionally present. When an element is referred to as being "directly on," "directly connected to," or "directly coupled to" another element or layer, there may not be any other intermediate elements or layers present. For example, when a first element is described as being "coupled to" or "connected to" a second element, the first element may be directly coupled or connected to the second element, or the first element may be indirectly coupled or connected to the second element through one or more intermediate elements.

Dimensions of various elements, layers, or the like in the drawings may be exaggerated for clarity of illustration. Like reference numerals refer to like elements. As used herein, the term "and/or" includes any and all combinations of one or more of the associated listed items. In addition, the use of "may" when describing embodiments of the present disclosure relates to "one or more embodiments of the present disclosure." Expression such as "at least one of" when preceding a list of elements may modify the entire list of elements and may not modify the individual elements of the list. For example, the expression "at least one of a, b, or c" may represent only a, only b, only c, both a and b, both a and c, both b and c, all a, b, and c, or variations thereof. As used herein, the terms "use," "using," and "used" may be considered synonymous with the terms "utilize," "utilizing," and "utilized," respectively. As used herein, the term "substantially," "about," and similar terms are used as terms of approximation and not as terms of degree, and are intended to account for the inherent deviations in measured or calculated values that would be recognized by those of ordinary skill in the art.

Although the terms first, second, third, and the like may be used herein to describe various elements, components, regions, layers, and/or sections, these elements, components, regions, layers, and/or sections are not limited to these terms. These terms are used to distinguish one element, component, area, layer, or cross-section from another element, component, area, layer, or cross-section. Accordingly, a first element, a first component, a first region, a first layer, or a first cross section to be described below may be termed a second element, a second component, a second region, a second layer, or a second cross section without departing from the disclosure of the embodiments.

Spatially relative terms such as "below," "lower," "on," "upper," and the like may be used herein for convenience of description to describe the relationship of one element(s) or feature(s) to other elements or to features shown in the drawings. Spatially relative terms may include other directions of a device in use or operation in addition to the directions shown in the drawings. For example, when the device in the drawings is turned over, elements described as "below" or "beneath" other elements or features would then be disposed "above" or "over" the other elements or features. Thus, the term "below" may include both orientations of above and below. The device may be otherwise oriented (rotated 90 degrees or at other orientations), and the spatially relative descriptors used herein interpreted accordingly.

The terms used in this specification are merely used to describe embodiments of the present disclosure and are not intended to limit the present disclosure. As used herein, the singular form may also include the plural form unless the context clearly indicates otherwise. The terms "comprises," "comprising," "includes," and the like specify the presence of stated features, integers, steps, operations, elements, and/or components but do not preclude the presence or addition of one or more other functions, integers, steps, operations, elements, components, and/or groups thereof.

When embodiments may be implemented with a processor, the specific process order may be performed differently from the described order. For example, two consecutively described processes may be performed substantially at the same time or may be performed in an order opposite to the described order.

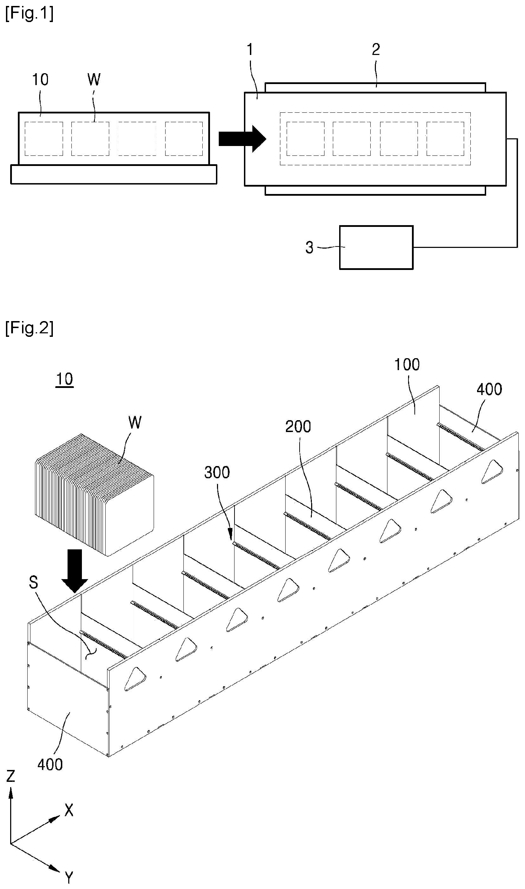

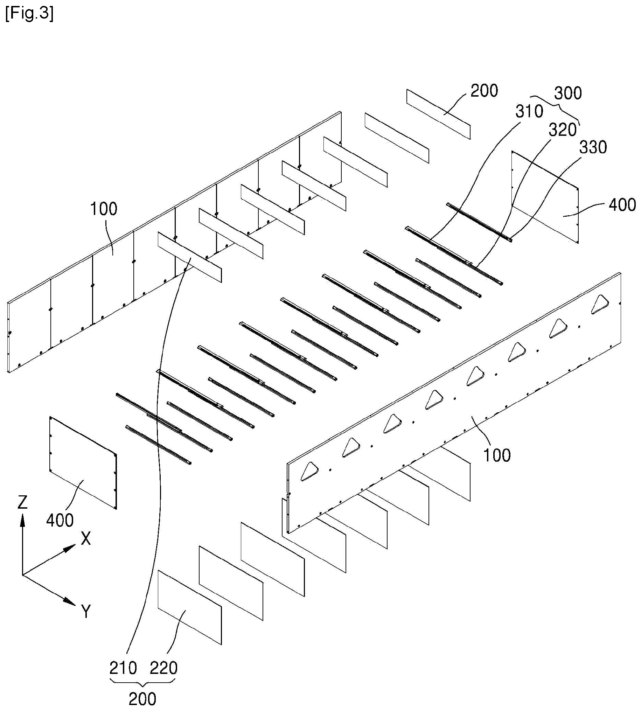

FIG. 1 illustrates a state in which a wafer boat 10 is loaded into a process chamber 1. FIG. 2 is a perspective view of the wafer boat 10. Although only a plurality of wafers W loaded in one loading region S is shown in FIG. 2, the plurality of wafers W may also be loaded in other loading regions S. FIG. 3 is an exploded perspective view of the wafer boat 10, and in FIG. 3, the plurality of wafers W are omitted for convenience of description.

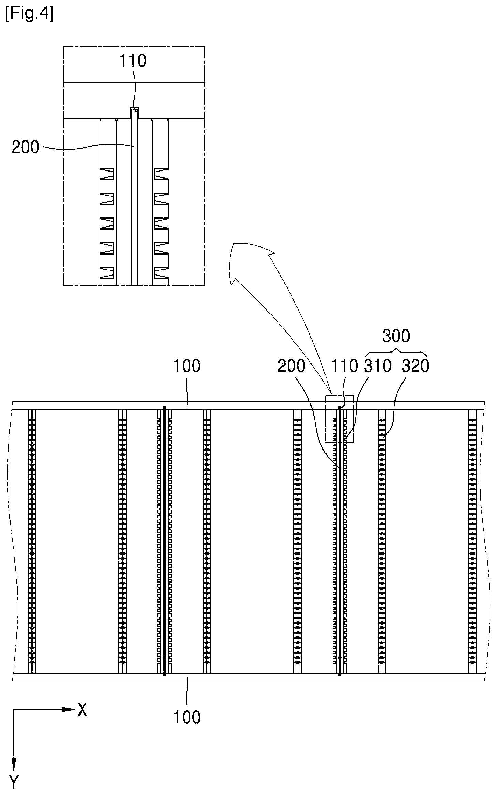

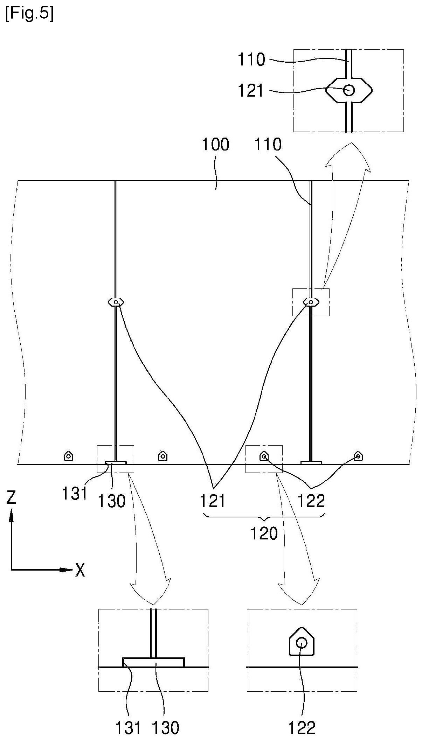

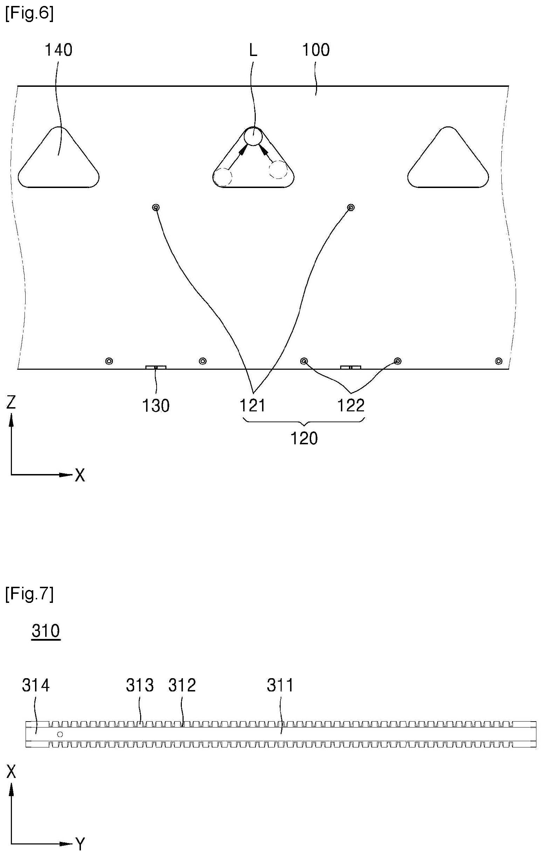

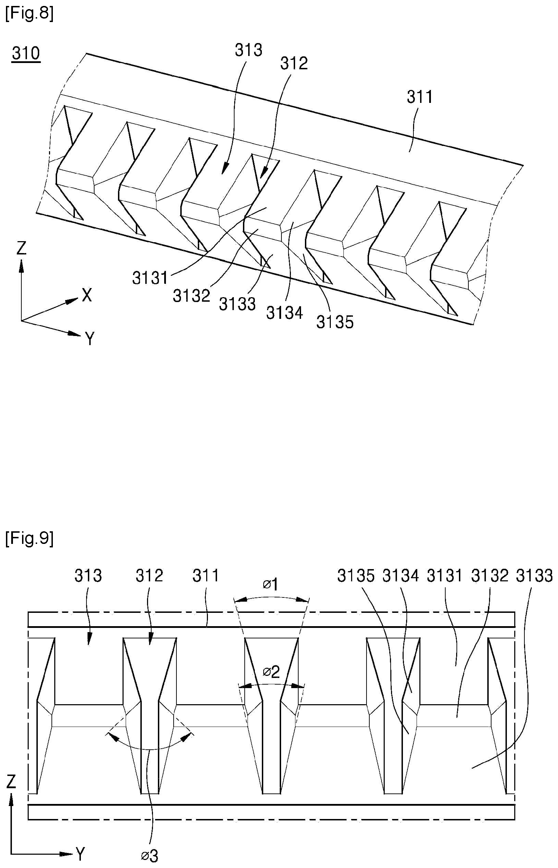

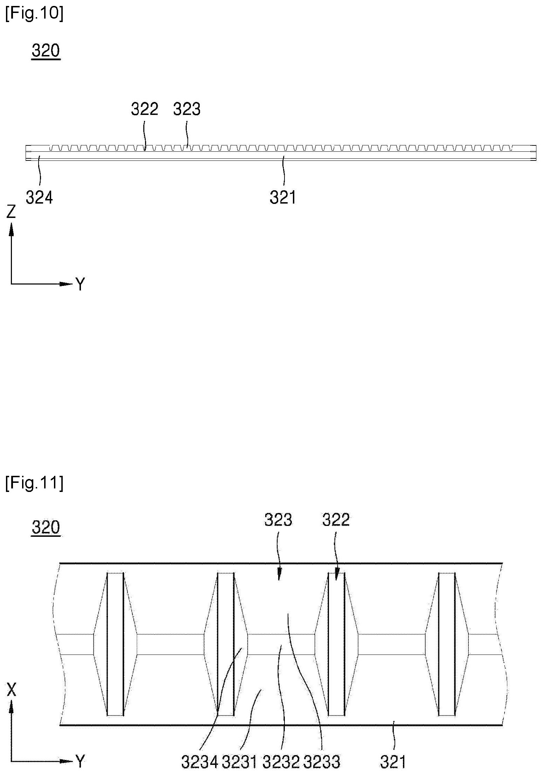

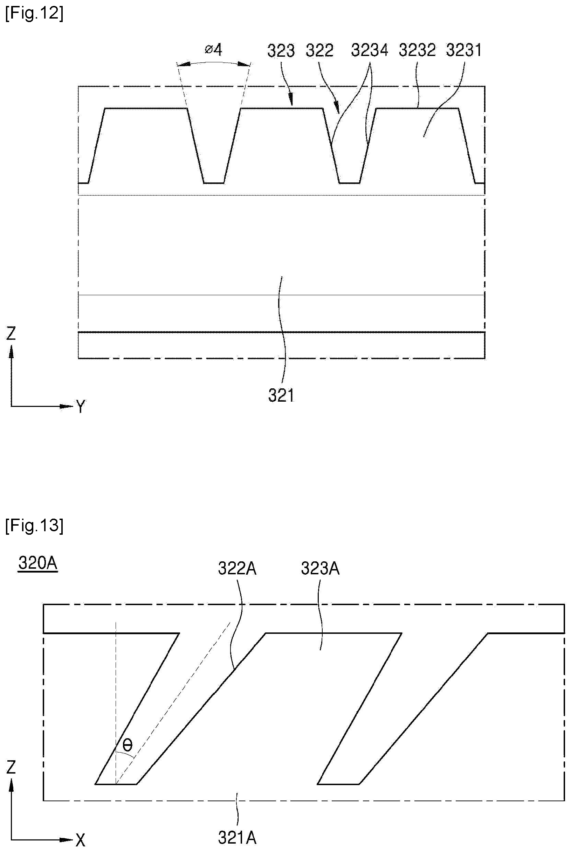

FIG. 4 is a plan view of a part of the wafer boat 10. FIG. 4 illustrates any region of the wafer boat 10 viewed from above other than an end portion thereof. FIG. 5 illustrates a portion of an inner surface that is one surface of a side plate 100. FIG. 6 illustrates a portion of an outer surface that is the other surface of the side plate 100. FIG. 7 illustrates a first guide bar 310 viewed from above. FIGS. 8 and 9 are enlarged views of a part of the first guide bar 310. FIG. 10 illustrates a second guide bar 320. FIGS. 11 and 12 are enlarged views of a part of the second guide bar 320.

The process chamber 1 may be a device for heat treatment of the wafer W, and for example, a deposition process of forming a thin film including a predetermined material layer on the wafer W may be performed therein. The process chamber 1 may have an internal space that is long in a horizontal direction such that the wafer boat 10 may be loaded therein. When the wafer boat 10 is loaded into the process chamber 1, a deposition gas is supplied from a gas supply source 3 into the process chamber 1, and a predetermined atmosphere is formed inside the process chamber 1. A heater 2 inside and/or outside the process chamber 1 may heat the process chamber 1 to perform a heat treatment process.

The wafer boat 10 may be used to store and transport the plurality of wafers W. One wafer boat 10 may be a batch-type boat capable of loading 100 or more, 200 or more, or 300 or more wafers W. In addition, the wafer boat 10 may be a horizontal-type boat in which the plurality of wafers W are loaded in a horizontal direction. The wafer boat 10 may be made of metal, for example, an aluminum alloy. The wafer boat 10 may be used to load the plurality of wafers W into the process chamber 1 and unload the plurality of wafers W, on which a process has been completed, from the process chamber 1.

The wafer boat 10 may include side plates 100, separators 200, guide bars 300, and end plates 400.

One or more side plates 100 may be provided at one or more sides of the wafer boat 10 and may support other components of the wafer boat 10, such as the separators 200, the guide bars 300, and the end plates 400. For example, the side plate 100 may extend in one direction (for example, an X-axis direction that is a longitudinal direction of the wafer boat 10). Two side plates 100 may be provided to be spaced apart from each other in a width direction (for example, a Y-axis direction) of the wafer boat 10. The separator 200 may be located between the two side plates 100 so that the loading region S in which the plurality of wafers W are loaded may be divided. In addition, the end plates 400 may be provided at both end portions of the two side plates 100. The loading region S may be appropriately selected according to the specifications, capacity, and the like of the wafer boat 10. For example, as shown in FIG. 2, there may be eight loading regions S. Alternatively, the number of the loading regions S may be eight or less or eight or more. Tens or hundreds of wafers W may be loaded in one loading region S.

The side plate 100 may be made of an aluminum alloy. In addition, the side plate 100 may have a predetermined surface roughness value through surface treatment. For example, the side plate 100 may be subjected to a sanding process to have a surface roughness value. For example, an average roughness value Ra of the side plate 100 may be about 9 µm or more. Here, the average roughness value Ra is a center line average height Ra. Accordingly, when the wafer boat 10 is reused, it is possible to prevent a peeling phenomenon in which a surface of the side plate 100 is peeled off during a deposition process or a deposition material deposited on the side plate 100 is peeled off. In addition, surface cleaning costs can be reduced when the wafer boat 10 is reused. For example, the side plate 100 may be surface-treated to have a greater surface roughness value than other components of the wafer boat 10. Thus, a deposition material deposited during deposition can be more strongly bonded onto the side plate 100 which has a greater surface roughness value than other components. Accordingly, during a process, a deposition material deposited on the side plate 100 may be prevented from being peeled off from the side plate 100 to cause contamination or the like on the wafer W, and a deposition material deposited on the wafer W can have excellent uniformity characteristics.

The side plate 100 may include a mounting groove 110 into which the separator 200 is inserted. As shown in FIG. 4, the mounting groove 110 may be formed in an inner surface of the side plate 100 to extend downward in a height direction (for example, a Z-axis direction). The mounting groove 110 may extend linearly downward and may be concavely formed in the inner surface of the side plate 100. The mounting grooves 110 may be formed in the two side plates 100 to face each other. Both end portions of the separator 200 may be inserted into two facing mounting grooves 110.

The side plate 100 may include a support hole 120 that supports the guide bar 300. The support hole 120 may be formed in the side plate 100, and an end portion of the guide bar 300 may be inserted therein. For example, as shown in FIG. 5, the side plate 100 may include a plurality of support holes 120, and four support holes 120 may be formed in one loading region S. An end portion of one guide bar 300 may be inserted into each support hole 120. Accordingly, the guide bar 300 extending in the width direction of the wafer boat 10 between two side plates 100 may be inserted into the support hole 120 to support the plurality of wafers W.

The support hole 120 may include a first support hole 121 and a second support hole 122.

The first support hole 121 may be formed in the side plate 100 to correspond to the first guide bar 310. For example, as shown in FIGS. 5 and 6, two first support holes 121 may be formed in one loading region S to correspond to the mounting grooves 110 of the side plate 100. The first support hole 121 may be formed at a central portion or above the central portion of the side plate 100 in the height direction. The first support hole 121 may include a hole passing through the side plate 100 and a region concavely formed around the hole to form a step with the inner surface of the side plate 100. The concave region of the first support hole 121 may have a shape corresponding to a cross section of an end portion of the first guide bar 310. For example, as shown in the enlarged view of FIG. 5, the first support hole 121 may include a hexagonal concave groove and a groove formed inside the hexagonal concave groove. When the first guide bar 310 is inserted into the groove of the first support hole 121, a fastening member such as a bolt may be inserted from an outer surface of the side plate 100 to fix the first guide bar 310 to the first support hole 121.

The second support hole 122 may be formed in the side plate 100 to correspond to the second guide bar 320. For example, as shown in FIGS. 5 and 6, the second support hole 122 may be formed in a lower portion of the side plate 100 and may also be formed inside the first support hole 121. Two second support holes 122 may be formed in one loading region S. The second support hole 122 may include a hole passing through the side plate 100 and a concave region formed around the hole to form a step with the inner surface of the side plate 100. The concave region of the second support hole 122 may have a shape corresponding to the cross section of the end portion of the second guide bar 320. For example, as shown in the enlarged view of FIG. 5, the second support hole 122 may include a pentagonal concave groove and a groove formed inside the pentagonal concave groove. When the second guide bar 320 is inserted into the groove of the second support hole 122, a fastening member such as a bolt may be inserted from the outer surface of the side plate 100 to fix the second guide bar 320 to the second support hole 122.

A bracket 130 may be located at the lower portion of the side plate 100 and may support the separator 200 inserted into the mounting groove 110. For example, as shown in FIG. 5, the bracket 130 may be installed in a cutout portion 131 of the side plate 100 formed in a lower end portion of the mounting groove 110. The bracket 130 may be coupled to the cutout portion 131 through a fastening member such as a bolt to prevent the separator 200 inserted into the mounting groove 110 from detaching downward from the mounting groove 110.

A support groove 140 may be formed in one surface of the side plate 100 and used to transport the wafer boat 10. For example, a plurality of support grooves 140 may be formed in the outer surface of the side plate 100, and a lift L may be inserted into the support groove 140 to lift the wafer boat 10. For example, the support groove 140 may be a triangular groove. As shown in FIG. 6, the support groove 140 may be a triangular groove of which a bottom side is disposed parallel to a ground surface, and a portion thereof corresponding to a vertex may have a curved shape. Therefore, even when the lift L is not inserted into an upper vertex of the support groove 140 at a time and is located at another vertex of the support groove 140 or another side of the support groove 140, the lift L is lifted and spontaneously located at the upper vertex of the support groove 140. Therefore, in the wafer boat 10, without a need to correct a position of the lift L several times, an effect of correcting the position of the lift L only with a shape of the support groove 140 can be obtained. The same number of the support grooves 140 as the loading regions S may be provided, and the support grooves 140 may be formed at positions corresponding to the respective loading regions S.

The separator 200 has a flat shape and divides the loading region S in which the plurality of wafers W are loaded. For example, the separator 200 may have a quadrangular flat plate shape and may be provided as a plurality of separators 200 spaced apart from each other in one direction (for example, the X-axis direction) between two side plates 100. The loading region S in which the plurality of wafers W are loaded may be divided between the respective separators 200. In addition, after the wafer boat 10 is loaded into the process chamber 1, the separator 200 allows a deposition gas to uniformly pass the plurality of wafers W, thereby enhancing deposition quality. When the separator 200 is not provided, a deposition gas sprayed from above the wafer boat 10 passes the wafer W and is discharged through a gas outlet formed in a lower portion of the process chamber 1. Since the gas outlet is located at a central portion of the process chamber 1, the deposition gas moves downward and is collected at the central portion and discharged. As a result, the density of the deposition gas on the wafers W located at both end portions is lowered, which lowers the deposition quality of the wafer W. On the other hand, since the wafer boat 10 includes the separator 200, a deposition gas sprayed from above may uniformly enter the loading region S divided by each separator 200 and may pass all of the plurality of wafers W loaded in each loading region S to then be discharged. For example, the wafer boat 10 may include seven separators 200, and eight loading regions S may be defined between the seven separators 200 and two end plates 400. However, the number of the separators 200 may vary according to the number of the loading regions S to be formed.

The separator 200 may be inserted into the mounting groove 110 formed in the side plate 100. As shown in FIG. 4, both end portions of the separator 200 may be inserted into the mounting grooves 110 formed in two side plates 100 to face each other. A height of the separator 200 may be lower than a height of the side plate 100.

The separator 200 may be separated into two portions. For example, the separator 200 may include a first separator 210 located above the first guide bar 310 and a second separator 220 located below the first guide bar 310. The second separator 220 may be first inserted into the mounting groove 110 and located at a lower portion of the mounting groove 110. Thereafter, the first guide bar 310 may be installed in the first support hole 121, and then the first separator 210 may be inserted into the mounting groove 110. Accordingly, the first separator 210 and the second separator 220 may be located above and below the first guide bar 310.

The separator 200 may be made of an aluminum alloy. In addition, the separator 200 may have a predetermined surface roughness value through surface treatment. For example, the separator 200 may be subjected to a sanding process to have a surface roughness value. For example, the average roughness value Ra of the separator 200 may be about 3.2 µm or less. Accordingly, when the wafer boat 10 is reused, it is possible to prevent a peeling phenomenon in which a surface of the separator 200 is peeled off during a deposition process or a deposition material deposited on the side plate 100 is peeled off. In addition, surface cleaning costs can be reduced when the wafer boat 10 is reused.

The separator 200 may have a surface roughness value smaller than that of the side plate 100. For example, the average roughness value Ra of the separator 200 may be about 35% or less of the average roughness value Ra of the side plate 100. Therefore, when the wafer W is inserted into the loading region S, even when the wafer W comes into contact with the separator 200, damage to the wafer W can be minimized due to the surface roughness of the separator 200.

The guide bar 300 may guide a position at which the plurality of wafers W are inserted and may support the plurality of wafers W. A plurality of guide bars 300 may be provided in each loading region S. The plurality of guide bars 300 may be provided in the width direction (for example, the Y-axis direction) of the wafer boat 10 to intersect the longitudinal direction (for example, the X-axis direction) of the wafer boat 10. Each guide bar 300 may be located between two side plates 100. For example, four guide bars 300 may be provided in one loading region S.

The guide bar 300 may be made of an aluminum alloy. In addition, the guide bar 300 may have a predetermined surface roughness value through surface treatment. For example, the guide bar 300 may be subjected to a sanding process to have a surface roughness value. For example, the average roughness value Ra of the guide bar 300 may be about 3.2 µm or less. Accordingly, when the wafer boat 10 is reused, it is possible to prevent a peeling phenomenon in which a surface of the guide bar 300 is peeled off during a deposition process or a deposition material deposited on the side plate 100 is peeled off. In addition, surface cleaning costs can be reduced when the wafer boat 10 is reused.

The guide bar 300 may have a surface roughness value corresponding to that of the separator 200. For example, the average surface roughness value Ra of the guide bar 300 may correspond to the average roughness value Ra of the separator 200. Here, the average surface roughness values Ra corresponding to each other may mean that the average surface roughness values Ra are within the same error range. In addition, the guide bar 300 may have a surface roughness value smaller than that of the side plate 100. For example, the average roughness value Ra of the guide bar 300 may be about 35% or less of the average roughness value Ra of the side plate 100. Therefore, when the wafer W is inserted into the loading region S, even when the wafer W comes into contact with the guide bar 300, damage to the wafer W can be minimized due to the surface roughness of the guide bar 300.

In addition, a coating layer (not shown) may be further formed on the guide bar 300. For example, the guide bar 300 may be subjected to a coating process after surface treatment. For example, the guide bar 300 may be subjected to an anodizing process after being subjected to a sanding process, and a coating layer may be further formed on the surface of the guide bar 300. A coating layer including aluminum oxide may be formed on the surface of the guide bar 300 through aluminum anodizing, thereby improving corrosion resistance, wear resistance, and coating adhesion.

In addition, the coating layer may be formed on the guide bar 300 so that the guide bar 300 may have a lower surface roughness value. For example, the average surface roughness value Ra of the guide bar 300 on which the coating layer is formed, for example, the average surface roughness value Ra of a surface of the coating layer, may be smaller than the average surface roughness value Ra of the guide bar 300 on which the coating layer is not formed. That is, the average roughness value Ra of the surface of the coating layer may be smaller than the average surface roughness value Ra of the guide bar 300 within a range of about 3.2 µm or less.

Accordingly, when the wafer W is inserted into the loading region S or removed from the loading region S, scratches or damage to the wafer W can be prevented or minimized due to the surface roughness of the guide bar 300.

The plurality of wafers W may be inserted into and supported by the guide bar 300 in a back-to-back (B-to-B) manner. That is, two wafers W may be inserted into one insertion groove included in the guide bar 300 in a state in which rear surfaces of the two wafers W are in contact with each other. Therefore, the rear surface of the wafer W that does not require deposition may be covered by another wafer W, and a deposition process may be performed in a state in which a front surface of the wafer W is exposed. Accordingly, it is possible to prevent a deposition material from being unnecessarily deposited on the rear surface of the wafer W.

In addition, since a deposition process is performed in a state in which two wafers W are in contact with each other, the number of first insertion grooves 312 to be described below can be minimized, and process efficiency can be maximized. In addition, since two wafers W are inserted into and disposed in the first insertion groove 312, it is possible to minimize shaking such as vibration that occurs in the wafers W in the first insertion groove 312 during a process.

The guide bar 300 may include the first guide bar 310 and the second guide bar 320.

The first guide bar 310 may be a component that first comes into contact with the plurality of wafers W when the plurality of wafers W are inserted into the loading region S. A plurality of first guide bars 310 of the plurality of guide bars 300 may be provided at an upper side. For example, two first guide bars 310 may be spaced apart from each other in the longitudinal direction (for example, the X-axis direction) of the wafer boat 10. A distance between the two first guide bars 310 may correspond to a length of the wafer W in one direction. Both end portions of the first guide bar 310 may be inserted into two first support holes 121 formed in two side plates 100. In a state in which both end portions of the first guide bar 310 are inserted into the two first support holes 121, a fastening member such as a bolt may be inserted into the first support hole 121 from the outside of the side plate 100 to fix the first guide bar 310 to the side plate 100.

The first guide bar 310 may include a first body 311, the first insertion groove 312, a first insertion protrusion 313, and an end portion 314.

The first body 311 may have a rod shape that is long in one direction (for example, the X-axis direction), and the plurality of first insertion grooves 312 and a plurality of first insertion protrusions 313 may be formed at each of one side and the other side of the first body 311. In addition, the end portions 314 inserted into the first support holes 121 may be formed at both end portions of the first body 311 in a longitudinal direction. Upper and lower surfaces of the first body 311 may have a flat shape, and the plurality of first insertion grooves 312 and the plurality of first insertion protrusions 313 may be formed in both protruding side surfaces thereof.

The first insertion groove 312 may be a groove into which the wafer W is inserted and supported and may be formed between two adjacent first insertion protrusions 313. Two wafers W may be inserted into one first insertion groove 312 in a B-to-B manner. The first insertion groove 312 and the first insertion protrusion 313 may be formed at each of one side and the other side of the first body 311. The first insertion groove 312 may have a shape of which a width gradually decreases from an outer side to an inner side in a width direction (for example, the X-axis direction) of the first guide bar 310. For example, as shown in FIG. 7, when viewed from above, the first insertion groove 312 may be a V-shaped groove. The first insertion groove 312 may have a shape of which a width gradually decreases from top to bottom in a height direction (for example, the Z-axis direction) of the first guide bar 310. For example, as shown in FIG. 8, when viewed from the side, the first insertion groove 312 may be a V-shaped groove. In this way, the first insertion groove 312 has a V-shape of which a width gradually decreases in the width direction and/or height direction of the first guide bar 310, thereby guiding the first wafer W to be initially spontaneously inserted into the first insertion groove 312 while firmly supporting the wafer W to prevent the wafer W from shaking during a process.

The first insertion protrusion 313 may include a first protruding surface 3131, a second protruding surface 3132, a third protruding surface 3133, a first support surface 3134, and a second support surface 3135.

The first protruding surface 3131 may extend obliquely downward from an upper surface of the first body 311. The second protruding surface 3132 may extend downward (for example, vertically) from an end portion of the first protruding surface 3131, and the third protruding surface 3133 may extend obliquely downward from an end portion of the second protruding surface 3132 toward a lower surface of the first body 311. Accordingly, as shown in FIG. 8, a protruding surface divided into the first protruding surface 3131, the second protruding surface 3132, and the third protruding surface 3133 may protrude from the first body 311 to one side to support the wafer W inserted into the first insertion groove 312.

The first support surface 3134 may be formed at each of two sides of the first protruding surface 3131, and the second support surface 3135 may be formed at each of two sides of the third protruding surface 3133. As shown in FIG. 8, the first support surface 3134 may be formed at each of two sides of the first protruding surface 3131, and a lower end portion thereof may correspond to the second protruding surface 3132. In addition, the second support surface 3135 may be formed at each of two sides of the third protruding surface 3133, and an upper end portion thereof may be in contact with the first support surface 3134 and may correspond to the second protruding surface 3132.

The first support surface 3134 may have a shape inclined toward the first insertion groove 312 in the width direction of the first guide bar 310. The second support surface 3135 may have a shape inclined toward the first insertion groove 312 in the width direction of the first guide bar 310. Therefore, when viewed from above, the first insertion groove 312 may have a V-shape of which a width gradually decreases toward an inner side in the width direction of the first guide bar 310.

The first support surface 3134 may have a shape that is inclined downward toward the first insertion groove 312 in the longitudinal direction of the first guide bar 310. Since two first support surfaces 3134 have a shape inclined toward an inner side of the first insertion groove 312, the first insertion groove 312 may have a V shape of which a width gradually decreases from top to bottom. A side of the second support surface 3135 in contact with the first insertion groove 312 may extend vertically downward. Accordingly, the first insertion groove 312 defined by the first support surface 3134 and the second support surface 3135 may have a shape of which a width gradually decreases downward to a boundary between the first support surface 3134 and the second support surface 3135 and may have a constant width from the second support surface 3135 to a lower end thereof. Therefore, when the wafer W is initially inserted into the first insertion groove 312, the wafer W may be spontaneously inserted into an upper portion of the first insertion groove 312 having a relatively wide width and then may be firmly supported on a lower portion of the first insertion groove 312 having a relatively narrow width and formed between two second support surfaces 3135.

A side at which the second protruding surface 3132 is in contact with the first support surface 3134 may have a shape of which at least a portion is chamfered. For example, as shown in FIG. 8, the second protruding surface 3132 may have a shape of which portions corresponding to vertices of a rectangle are chamfered when viewed from the front. Therefore, a leading end of the first support surface 3134 may not be in point contact with the second protruding surface 3132 but may be in surface contact with an edge of the second protruding surface 3132. Since the first insertion protrusion 313 has such a shape, when the wafer W is inserted into the first insertion groove 312, damage to the wafer W caused by coming into contact with the second protruding surface 3132 and a protruding leading end of the first support surface 3134 can be prevented.

As shown in FIG. 9, at least some of the first protruding surface 3131, the second protruding surface 3132, the third protruding surface 3133, the first support surface 3134, and the second support surface 3135 of the first insertion protrusion 313 may have different inclinations. For example, two adjacent first support surfaces 3134 may have a first angle θ1. That is, an angle between the two first support surfaces 3134 facing each other with the first insertion groove 312 interposed therebetween may be the first angle θ1. Here, the first angle θ1 may be an angle between edges of the two first support surfaces 3134 that are in contact with a lower surface of the first insertion groove 312. In addition, two adjacent second support surfaces 3135 may have a second angle θ2. That is, an angle between the two second support surfaces 3135 with the first insertion groove 312 interposed therebetween may be the second angle θ2. Here, the second angle θ2 may be an angle between edges of the two second support surfaces 3135 that are in contact with the third protruding surfaces 3133. In addition, an angle formed at a boundary line between the first support surface 3134 and the second support surface 3135 may be a third angle θ3. That is, an angle at which the boundary line between the first support surface 3134 and the second support surface 3135 extends from the lower surface of the first insertion groove 312 may be the third angle θ3. For example, the first angle θ1 may be greater than the second angle θ2. For example, the first angle θ1 may be in a range of 25 degrees to 35 degrees, and the second angle θ2 may be in a range of 10 degrees to 20 degrees. Alternatively, the first angle θ1 may be in a range of 20 degrees to 40 degrees, and the second angle θ2 may be in a range of 5 degrees to 25 degrees. In addition, the third angle θ3 may be smaller than the first angle θ1 and greater than the second angle θ2. For example, the third angle θ3 may be in a range of 20 degrees to 30 degrees. Alternatively, the third angle θ3 may be in a range of 15 degrees to 35 degrees. Since the first angle θ1, the second angle θ2, and the third angle θ3 satisfy the above-described size relationship, the wafer W can be smoothly inserted into and removed from the first guide bar 310, and the wafer W can be firmly supported on and fixed to the first guide bar 310.

The second guide bar 320 may be located below the first guide bar 310 to support lower portions of the plurality of wafers W. A plurality of second guide bars 320 of the plurality of guide bars 300 may be provided at a lower side. For example, two second guide bars 320 may be spaced apart from each other in the longitudinal direction (for example, the X-axis direction) of the wafer boat 10. A distance between the two second guide bars 320 may be smaller than the distance between the two first guide bars 310. Therefore, when viewed from the side of the wafer boat 10, a virtual line connecting the two first guide bars 310 and the two second guide bars 320 may form a trapezoidal shape with a longer upper side. Both end portions of the second guide bar 320 may be inserted into two second support holes 122 formed in two side plates 100. In a state in which both end portions of the second guide bar 320 are inserted into the two second support holes 122, a fastening member such as a bolt may be inserted into the second support hole 122 from the outside of the side plate 100 to fix the second guide bar 320 to the side plate 100.

The second guide bar 320 may include a second body 321, a second insertion groove 322, a second insertion protrusion 323, and an end portion 324.

The second body 321 may have a rod shape that is long in one direction (for example, the X-axis direction), and a plurality of second insertion grooves 322 and a plurality of second insertion protrusions 313 may be formed at each of one side and the other side of the second body 321. In addition, the end portions 324 inserted into the second support holes 122 may be formed at both end portions of the second body 321 in a longitudinal direction. Upper and lower surfaces of the second body 321 may have a flat shape, and the plurality of second insertion grooves 322 and the plurality of second insertion protrusions 323 may be formed in both protruding side surfaces thereof.

The second insertion groove 322 may be a groove into which the wafer W is inserted and supported and may be formed between two adjacent second insertion protrusions 323. Two wafers W may be inserted into one second insertion groove 322 in a B-to-B manner. The second insertion groove 322 and the second insertion protrusion 323 may be formed at each of one side and the other side of the second body 321. The second insertion groove 322 may have a shape of which a width gradually decreases from an outer side to an inner side in a width direction (for example, the X-axis direction) of the second guide bar 320. For example, as shown in FIG. 10, when viewed from one side (for example, the front in the Y-axis direction), the second insertion groove 322 may be a V-shaped groove. The second insertion groove 322 may have a shape of which a width gradually decreases from top to bottom in a height direction (for example, the Z-axis direction) of the second guide bar 320. For example, as shown in FIG. 10, when viewed from the side, the second insertion groove 322 may be a V-shaped groove. In this way, the second insertion groove 322 has a V-shape of which a width gradually decreases in the width direction and/or height direction of the second guide bar 320, thereby guiding the first wafer W to be initially spontaneously inserted into the second insertion groove 322 while firmly supporting the wafer W to prevent the wafer W from shaking during a process.

The second insertion protrusion 323 may include a fourth protruding surface 3231, a fifth protruding surface 3232, a sixth protruding surface 3233, and a third support surface 3234.

The fourth protruding surface 3231 may extend obliquely upward from one side surface of the second body 321, and the sixth protruding surface 3233 may extend obliquely upward from the other side surface of the second body 321. In addition, the fifth protruding surface 3232 may be located between the fourth protruding surface 3231 and the sixth protruding surface 3233. Accordingly, as shown in FIG. 10, a protruding surface divided into the fourth protruding surface 3231, the fifth protruding surface 3232, and the sixth protruding surface 3233 may protrude upward from the second body 321 to support the wafer W inserted into the second insertion groove 322.

The third support surface 3234 may be formed at each of two sides of the second insertion protrusion 323. As shown in FIG. 10, the third support surface 3234 may be formed between the fourth protruding surface 3231, the fifth protruding surface 3232, and the sixth protruding surface 3233, and the second insertion groove 322. The third support surface 3234 may have a shape inclined toward the second insertion groove 322 in a width direction of the second guide bar 320. Therefore, when viewed from above, the second insertion groove 322 may have a V-shape of which a width gradually decreases toward an inner side in the width direction of the second guide bar 320.

The third support surface 3234 may have a shape inclined downward toward the second insertion groove 322 in the longitudinal direction of the second guide bar 320. Since two third support surfaces 3234 have a shape inclined toward an inner side of the second insertion groove 322, the second insertion groove 322 may have a V-shape of which a width gradually decreases from top to bottom. Therefore, when the first wafer W is initially inserted into the second insertion groove 322, the first wafer W may be spontaneously inserted into an upper portion of the second insertion groove 322 having a relatively wide width and then may be firmly supported on a lower portion of the second insertion groove 322 having a relatively narrow width.

As shown in FIG. 12, two adjacent third support surfaces 3234 may have a fourth angle θ4. That is, an angle between the two third support surfaces 3234 facing each other with the second insertion groove 322 interposed therebetween may be the fourth angle θ4. For example, the fourth angle θ4 may be smaller than the first angle θ1. In addition, the fourth angle θ4 may be smaller than the third angle θ3. In addition, the fourth angle θ4 may be smaller than the third angle θ3. For example, the fourth angle may be in a range of 10 degrees to 20 degrees. Alternatively, the fourth angle may be in a range of 5 degrees to 25 degrees. Since the fourth angle θ4 satisfies the above-described size relationship with the first angle θ1, the second angle θ2, and the third angle θ3, the wafer W can be smoothly inserted into and removed from the second guide bar 320, and the wafer W can be firmly supported on and fixed to the second guide bar 320. An end guide bar 330 may be provided at one side of the end plate 400. For example, the end guide bar 330 may be provided on an inner surface of each of two end plates 400. The end guide bar 330 may support the wafer W with the first guide bar 310 adjacent thereto. The end guide bar 330 may have a shape corresponding to half of that of the first guide bar 310 in one direction (for example, the X-axis direction). For example, the end guide bar 330 may have the same shape as the first guide bar 310 in which the first insertion groove 312 and the first insertion protrusion 313 are formed only at one side thereof.

The end plate 400 may be provided at an end portion of the wafer boat 10 in the longitudinal direction (for example, the X-axis direction). For example, as shown in FIG. 3, two end plates 400 may each be provided at one of two end portions of the wafer boat 10 in the longitudinal direction to form the loading regions S with the separators 200 close thereto. The end guide bar 330 may be located on an inner surface of the end plate 400.

The end plate 400 may be made of an aluminum alloy. In addition, the end plate 400 may have a predetermined surface roughness value through surface treatment. For example, the end plate 400 may be subjected to a sanding process to have a surface roughness value. For example, the average roughness value Ra of the end plate 400 may be about 9 µm or more. Accordingly, when the wafer boat 10 is reused, it is possible to prevent a peeling phenomenon in which a surface of the end plate 400 is peeled off during a deposition process or a deposition material deposited on the side plate 100 is peeled off. In addition, surface cleaning costs can be reduced when reusing the wafer boat 10. For example, the end plate 400 may be surface-treated to have a greater surface roughness value than other components of the wafer boat 10. For example, the end plate 400 may have a surface roughness value corresponding to that of the side plate 100. Specifically, one surfaces of the end plate 400 and the side plate 100 which each face the wafer W may have the average roughness values Ra that correspond to each other within an error range.

Thus, a deposition material deposited during deposition can be more strongly bonded to the end plate 400 which has a greater surface roughness value than other components. Accordingly, during a process, a deposition material deposited on the end plate 400 can be prevented from being peeled off from the end plate 400 to cause contamination or the like on the wafer W, and a deposition material deposited on the wafer W can have excellent uniformity characteristics.

FIG. 13 illustrates a second guide bar 320A according to another embodiment.

A shape of a second insertion groove 32A of the second guide bar 320A may be different from that of the second guide bar 320 described above, and other components thereof may be the same as those of the second guide bar 320. Hereinafter, for convenience of description, the second insertion groove 322A will be mainly described.

The second guide bar 320A may include a second body 321A, a second insertion groove 322A, and a second insertion protrusion 323A.

The second insertion groove 322A may be inclined at an angle θ with respect to a vertical axis (for example, a Z axis). The angle θ may be in a range of 10 degrees to 80 degrees, 20 degrees to 60 degrees, or 30 degrees to 45 degrees. For example, the angle θ may be in a range of 25 degrees to 35 degrees. The wafer W may be supported in the second insertion groove 322A in a state of being inclined by an inclination of the second insertion groove 322A. Accordingly, a lower portion of the wafer W may be supported by an inclined surface of the second insertion groove 322 to be supported more stably in the second insertion groove 322A.

As described above, the present disclosure has been described with reference to embodiments shown in the drawings, but this is only an example. Those of ordinary skill in the art may fully understand that various modifications and equivalent other embodiments are possible from the embodiments. Therefore, the true technical protection scope of the present disclosure should be determined based on the appended claims.

## Claims

1. A wafer boat comprising:
a pair of side plates;
separators located at a predetermined interval between the pair of side plates and configured to divide a loading region into which a plurality of wafers are inserted; and
guide bars configured to support the wafers between the pair of side plates,
wherein one or more of the separators and the guide bars have an average surface roughness value (Ra) that is different from the average surface roughness value (Ra) of the pair of side plates.

2. The wafer boat of claim 1, wherein the separators and the guide bars are subjected to a sanding process to have an average surface roughness value (Ra) that is smaller than that of the pair of side plates.

3. The wafer boat of claim 1, wherein the guide bar includes:
two first guide bars which include a plurality of first insertion grooves configured to support one side of each of the wafers and a plurality of first insertion protrusions configured to define the plurality of first insertion grooves and are spaced apart from each other; and
two second guide bars which include a plurality of second insertion grooves configured to support the other side of each of the wafers and a plurality of second insertion protrusions configured to define the plurality of second insertion grooves, are located below the first guide bars, and are spaced apart from each other by a narrower interval than the two first guides,
wherein the plurality of first insertion grooves and the plurality of second insertion grooves have a shape of which a width gradually decreases toward an inner side.

4. The wafer boat of claim 3, wherein the first guide bar further includes a plurality of first insertion protrusions which are located between the plurality of first insertion grooves and each of which at least a portion of an edge of a surface into which the wafer is inserted is chamfered.

5. The wafer boat of claim 3, wherein the first insertion protrusion includes:
a first protruding surface extending obliquely downward;
a second protruding surface extending from an end portion of the first protruding surface;
a third protruding surface extending obliquely downward from an end portion of the second protruding surface;
a first support surface provided at each of two sides of the first protruding surface and provided in contact with the first insertion groove; and
a second support surface provided at each of two sides of the third protruding surface and provided in contact with the first insertion groove,
wherein a portion of an edge of the second protruding surface in contact with the first support surface is chamfered.

6. The wafer boat of claim 5, wherein a line of the first support surface in contact with the first insertion groove gradually decreases in a height direction of the first guide bar, and
a portion of the second support surface in contact with the first insertion groove vertically extends in the height direction of the first guide bar.

7. The wafer boat of claim 1, wherein the side plate includes:
a mounting groove, into which both end portions of the separator are inserted, formed in an inner surface of the side plate; and
a bracket installed in a cutout portion formed in a lower end portion of the mounting groove to support the separator.

8. The wafer boat of claim 1, wherein the side plate includes a triangular support groove concavely formed in an outer surface thereof.

9. The wafer boat of claim 1, wherein the wafer boat further includes a coating layer formed on the guide bar, and
an average surface roughness value (Ra) of the coating layer is smaller than an average surface roughness value (Ra) of the guide bars.
